(19) **Europäisches Patentamt**
**European Patent Office**
**Office européen des brevets**

(11) **EP 2 853 619 A1**

(12) **EUROPEAN PATENT APPLICATION**

(43) Date of publication:
01.04.2015 Bulletin 2015/14

(51) Int Cl.:
$C23C\ 18/24$ (2006.01)  $C23C\ 18/54$ (2006.01)
$H05K\ 3/00$ (2006.01)

(21) Application number: 13185890.4

(22) Date of filing: 25.09.2013

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Atotech Deutschland GmbH
10553 Berlin (DE)**

(72) Inventors:
• **Steinhäuser, Dr. Edith
10315 Berlin (DE)**

• **Wiese, Stefanie
10825 Berlin (DE)**
• **Gregoriades, Dr. Laurence John
10439 Berlin (DE)**
• **Schiemann, Julia
10245 Berlin (DE)**
• **Stamp, Dr. Lutz
13509 Berlin (DE)**

(74) Representative: **Wonnemann, Jörg
Atotech Deutschland GmbH
Patent Management
Erasmusstraße 20
10553 Berlin (DE)**

(54) **Method for treatment of recessed structures in dielectric materials for smear removal**

(57) The present invention relates to a method for treatment of recessed structures in a dielectric material for smear removal during the manufacture of printed circuit boards, IC substrates and the like. The dielectric material is contacted with an aqueous solution comprising 60 to 80 wt.-% sulfuric acid and 0.04 to 0.66 mol/l peroxodisulfate ions peroxodisulfate ions. Smear is removed from the recessed structures by the method according to the present invention without penetration of process chemicals into the dielectric material and a sufficiently low copper etching rate is achieved.

**Description**

**Field of the Invention**

The present invention relates to a method for treatment of recessed structures in dielectric materials for smear removal in the manufacture of printed circuit boards, IC substrates and the like.

**Background of the Invention**

Recessed structures such as through holes (THs) and blind micro vias (BMVs) need to be formed in dielectric materials and later plated with copper to provide an electrical contact between individual layers of a multilayer printed circuit board, IC substrate and related devices. Said recessed structures are for example formed by mechanical drilling, laser drilling or plasma erosion. The smear (residues from the dielectric material) created during formation of said recessed structures needs to be removed from the dielectric material, copper structures and/or copper layer(s) before the dielectric walls of the recessed structures are activated for successive conformal plating or filling with copper by electroplating. Smear not removed causes an insufficient adhesion of the copper later deposited and the dielectric walls of the recessed structures.

The dielectric material in which the recessed structures are formed contains a thermoplastic polymer, for example an epoxy resin, polyimide, cyanate esters and polyester. Such dielectric materials usually comprise also a second material for reinforcement such as glass fibers and/or glass balls and in addition copper structures and/or copper layer(s).

The current standard method for removal of smear comprises three steps:

1. swelling the dielectric material with an alkaline aqueous solution comprising an organic solvent,

2. etching the dielectric materials with an alkaline solution comprising permanganate ions and

3. reducing $MnO_2$ formed during etching.

Alternative methods using highly acidic media for etching such as permanganate ions in concentrated sulfuric acid or chromic acid are also known in the art but have no practical relevance. Both permanganate ions and chromic acid need to be replaced because of their toxic properties. A technological disadvantage of known acidic methods for removal of smear is that siloxane-ether linkers between the glass reinforcement and the thermoplastic polymer in the dielectric material are broken and process chemicals can penetrate into the dielectric material and cause a failure known as "wicking".

A method for smear removal utilizing an oxidizing agent in concentrated sulfuric acid (at least 92 wt.-%) is disclosed in EP 0 216 513. The strong acidic solution causes undesired "wicking" and furthermore leads to an undesirable high etching rate of copper during removal of smear. This high copper etching rate is not acceptable especially in case of fine copper structures and/or thin copper layers present in recent printed circuit boards, IC substrates and the like.

An aqueous solution of 200 g/l ammonium peroxodisulfate for the removal of metal burrs caused by laser drilling is disclosed in US 4,023,998. This method is not suitable to remove smear from the dielectric material (Example 2 (comparative)).

**Objective of the present Invention**

The objective of the present invention is to provide a method for smear removal after formation of recessed structures in dielectric materials during the manufacture of printed circuit boards, IC substrates and the like which avoids toxic chemicals such as permanganate ions and chromic acid and which suppresses undesired phenomena such as penetration of process chemicals into the dielectric material ("wicking") and a too strong etching of copper structures and/or copper layer(s). Furthermore, the number of process steps should be reduced compared to known methods such as the alkaline method with permanganate ions.

**Summary of the Invention**

This objective is solved by a method for treatment of recessed structures in a dielectric material for smear removal comprising, in this order, the steps of

(i) providing a dielectric substrate comprising at least one recessed structure which contains residues of said dielectric material formed during manufacture of said recessed structures and

(ii) contacting said dielectric substrate with an aqueous solution comprising 60 to 80 wt.-% sulfuric acid and 0.04 to 0.66 mol/l peroxodisulfate ions and thereby removing said residues of dielectric material from the dielectric substrate.

The method for treatment of recessed structures in a dielectric material according to the present invention does not utilize toxic materials such as permanganate ions and chromic acid. Etching of copper is low as desired and smear removal from the dielectric material is sufficiently high as determined by the weight loss of dielectric material when applying the method according to the present invention. Furthermore, undesired penetration of process chemicals into the dielectric material ("wicking") is suppressed because the siloxane-ether linkers between the glass reinforcement and the thermoplastic polymer in the dielectric material are not broken. Also the number of process steps is reduced, because the reducing step required when using permanganate ions is not required in the method according to the present invention. Furthermore, the copper etching rate is sufficiently low.

In a preferred embodiment of the present invention, the swelling step with an aqueous solution comprising an organic solvent is also not required.

Hence, the method according to the present invention is well suited to clean the recessed structures of dielectric materials after formation of said recessed structures and leading to a desirably high adhesion between the copper electroplated into the recessed structures in successive process steps and the dielectric material.

## Detailed Description of the Invention

Recessed structures (THs, BMVs and the like) are usually formed by mechanical drilling, laser drilling or plasma erosion. Other structures such as trenches can also be formed by embossing techniques. In all those cases smear consisting of residues of the thermoplastic polymer in the dielectric material is formed which has to be completely removed prior to activation of the dielectric walls of the recessed structures for successive electroplating of copper. The exact chemical nature of said smear may vary depending on the method applied for manufacture of the recessed structures. The method according to the present invention is capable to remove smear formed by all standard drilling methods, independent of the exact chemical nature of the smear.

Dielectric materials to be treated with the method according to the present invention are based on thermoplastic polymers such as epoxy resins, polyimide, cyanate esters, polyester, acrylonitrile-butadiene-styrene copolymer (ABS), polycarbonates (PC), ABS-PC composites (acrylonitrile-butadiene-styrene - polycarbonate composites, also denoted ABS-PC blends), polyamide (PA) and polycyclo-olefine. Such dielectric materials usually comprise also a second material for reinforcement such as glass fibers and/or glass balls. The thermoplastic polymer and the glass reinforcement are chemically connected by siloxane-ether linkers in order to form a stable composite material.

The dielectric material may further comprises copper structures and/or copper layer(s).

A dielectric material comprising recessed structures is provided in step (i) of the method according to the present invention after those recessed structures have been formed.

The dielectric substrate is then contacted in step (ii) of the method according to the present invention with an aqueous solution comprising 60 to 80 wt.-% sulfuric acid, preferably 65 to 75 wt.-% sulfuric acid.

Said aqueous solution further comprises 0.04 to 0.66 mol/l peroxodisulfate ions, preferably 0.22 to 0.44 mol/l peroxodisulfate ions.

Water-soluble peroxodisulfate salts may be used to provide the required amount of peroxidisulfate ions in said aqueous solution. Suitable water-soluble peroxodisulfate salts are sodium peroxodisulfate, potassium peroxodisulfate, ammonium peroxidisulfate and mixtures of the aforementioned. Also peroxodi-sulfuric acid can be used alone as the source for peroxodisulfate ions or in a mixture together the aforementioned water-soluble peroxodisulfate salts.

Ammonium peroxidisulfate is the most preferred source for peroxidisulfate ions because it is the most stable source for peroxidisulfate ions in the aqueous solution according to the present invention.

The concentration range of sulfuric acid in the aqueous solution applied in step (ii) of the method according to the present invention is mandatory because a sulfuric acid concentration too low does not remove the residues of the dielectric material after formation of the recessed structures. A sulfuric acid concentration too high leads to the undesired penetration of process chemicals into the dielectric material ("wicking") because the siloxane-ether linkers between the thermoplastic polymer of the dielectric material and the glass reinforcement are broken.

The concentration of peroxidisulfate ions must be kept within the above mentioned margins because a concentration too low does not sufficiently remove the residues of the dielectric material after formation of the recessed structures and a concentration too high leads to undesired precipitation of solid material in the aqueous solution.

The aqueous solution applied in step (ii) of the method according to the present invention may further comprises complexing agents for copper ions such as (poly)aminocarboxylates (e.g. ethylenediamine tetraacetic acid) and phosphonates (e.g. Nitrilotris(methylene phosphonic acid) and Ethane-1,2-bis(iminobis(methylene-phosphonic acid))); additives which improve the shelf life of said aqueous solution such as alcohols (e.g. iso-propanole) and polyols (e.g. polyethyleneglycol),

and corrosion inhibitors for copper such as triazoles (e.g. benzotriazole).

The dielectric substrate is contacted with the aqueous solution in step (ii) of the method according to the present invention preferably for 1 to 60 min, more preferably for 5 min to 40 min and most preferably for 10 min to 30 min.

The temperature of the aqueous solution is held in step (ii) of the method according to the present invention in the range of preferably 10 to 80 °C, more preferably 20 to 60 °C and most preferably 20 to 40 °C.

The method for treatment of recessed structures in dielectric materials for smear removal according to the present invention can be applied various types of equipment such as horizontal equipment, vertical equipment and vertically conveyorized equipment.

The dielectric substrate is optionally contacted with an aqueous solution comprising an organic solvent prior to step (ii). The organic solvent is for example a glycol such as butyl diglycol or an N-alkyl pyrrolidone such as N-methyl pyrrolidone and N-ethyl pyrrolidone. The concentration of the organic solvent preferable ranges from 20 to 80 wt.-%. Mixtures of solvents may also be used. The dielectric substrate is optionally contacted with said aqueous solution at a temperature in the range of 30 to 90 °C for 1 to 20 min. The removal of smear can be supported by said optional process step. When contacting the dielectric substrate with said aqueous solution, the thermoplastic polymer of the dielectric substrate swells and thereby the smear removal in step (ii) can be supported.

In one embodiment of the present invention, the dielectric substrate is rinsed after step (ii) with water comprising an alkaline substance, such as an alkali metal hydroxide (sodium hydroxide, potassium hydroxide, ammonium hydroxide and mixtures thereof). The pH-value of the alkaline rinse preferably ranges from 7 to 14. The alkaline rinse is necessary for the removal of organic residues arising from the oxidation of the dielectric substrate.

In one embodiment of the present invention, process step (ii) is supported by ultrasonic sound. The aqueous solution applied in step (ii) is in this embodiment agitated by means of ultrasonic equipment.

A support by ultrasonic sound during step (ii) of the method according to the present invention may be combined with a rinse with water containing an alkaline substance after step (ii).

The dielectric substrate having recessed structures is then suited for activation and successive copper plating and a sufficiently high adhesion between the dielectric substrate and the plated copper layer is achieved. Furthermore, undesired penetration of process chemicals in successive steps after applying the method according to the present invention is suppressed because the thermoplastic polymer and the glass reinforcement still adhere to each other.

A further technical advantage of the method according to the present invention compared to other acidic solutions utilized for removal of smear is the low copper etching rate during step (ii). This means that only a very small amount of copper is etched away when contacting the dielectric substrate with the acidic solution in step (ii). A low copper etching rate is particularly desired when the dielectric substrate comprises very fine copper structures and/or thin copper layers which should not be attacked by the acidic treatment solution applied in step (ii). The copper etching rate during step (ii) should not exceed 0.2 $\mu$m/min.

Activation of the dielectric substrate after smear removal (step (iii) is preferably achieved by contacting said dielectric substrate with a solution comprising ions and/or colloids of a catalytic metal which initiates electroless copper plating. Such catalytic active metals are for example palladium, silver and copper. Applicable activator compositions providing the catalytic metal in ionic or colloidal form are for example disclosed in ASM Handbook, Vol. 5 Surface Engineering, 1194, p. 317-318.

Next, the activated dielectric substrate is contacted in step (iv) of the method according to the present invention with an electroless copper plating bath composition and thereby depositing a first copper layer onto the activated dielectric substrate. Electroless copper plating electrolytes comprise generally a source of copper ions, pH modifiers, complexing agents such as EDTA, alkanol amines or tartrate salts, accelerators, stabilizer additives and a reducing agent. In most cases formaldehyde is used as reducing agent, other common reducing agents are hypophosphite, glyoxylic acid, dimethylamine borane and sodium borohydride. Typical stabilizer additives for electroless copper plating electrolytes are compounds such as mercaptobenzothiazole, thiourea, various other sulphur compounds, cyanide and/or ferrocyanide and/or cobaltocyanide salts, polyethyleneglycol derivatives, heterocyclic nitrogen compounds, methyl butynol, and propionitrile. (ASM Handbook, Vol. 5: Surface Engineering, pp. 311-312). Said first copper layer serves as the plating base for successive electroplating of copper (second copper layer).

**Examples**

The invention will now be illustrated by reference to the following non-limiting examples.

General procedure:

Two different types of test substrates were used throughout all examples: Test coupons type 1 only consisted of the bare dielectric material (Matsushita MC 100 EX: epoxy resin with glass reinforcement but without copper clad) and was used to determine the desired smear removal from the dielectric material by investigating the "weight loss" of said samples after applying the specific method for smear removal as indicated in the respective examples.

Test coupon type 2 consisted of the same dielectric material as substrate material 1 but further comprised a copper clad on both sides.

Both test coupon types had a size of 5 x 5 cm$^2$.

The capability of the different acidic solutions for smear removal was determined by weighting the dried test coupons type 1 on an analytical balance prior and after contacting with the various acidic solutions investigated. The weight loss is given in mg per dm$^2$ of test coupon type 1 surface (surfaces of front- and backside added). A weight loss of dielectric material in such a test in the range of 30 to 80 mg/dm$^2$ is desired. A weight loss below that range indicates that smear is not sufficiently removed from the dielectric material. A weight loss above said range indicates that not only smear but also a not acceptable amount of dielectric material itself is removed.

The copper etch rate of the acidic solutions was determined by weight loss on test coupons type 2. The substrate was weighted before the respective example and afterwards. The resulting weight loss $\Delta$ was calculated as

$$\Delta = [(\text{weight (before treatment)} - \text{weight (after treatement)}] / (\text{substrate surface})$$

A copper etching rate on the range of 0 to 0.2 $\mu$m/min is desired. A copper etching above that range is not acceptable because too much copper is removed during smear removal.

Example 1 (comparative)

Test coupons of type 1 and 2 were contacted with an acidic aqueous solution containing conc. H$_2$SO$_4$ (97 wt.-% H$_2$SO$_4$ in water) and 0.25 mol/l (5.7 wt.-%) ammonium peroxodisulfate (example according to EP 0 216 513 A2).

For the first test, the treatment solution temperature was adjusted to 30 °C and the treatment time was 3 min. The weight loss of the test coupon type 1 after treatment with said solution was 708.8 mg/dm$^2$. Accordingly, too much dielectric material is removed by such a treatment solution.

The copper etching rate was 0.031 $\mu$m/min.

For the second test, the treatment solution temperature was adjusted to 35 °C and the treatment time was 15 min. The weight loss of the test coupon after treatment with said solution was 2315 mg/dm$^2$. Again, too much dielectric material is removed from the substrate by such a treatment.

The copper etching rate as determined with a test coupon type 2 was 0.12 $\mu$m/min. Hence, the copper etching rate is acceptable.

During said second test the exothermic reaction leads to a temperature increase of the aqueous solution of 20 K in 15 min. This is not acceptable for safety reasons in the production of printed circuit boards and the like.

Example 2 (comparative)

Test coupons of type 1 and 2 were contacted with an aqueous solution of 200 g/l ammonium peroxodisulfate (example according to US 4,023,998). The treatment solution temperature was adjusted to 25 °C and the treatment time was 1.5 min.

Instead of weight loss, weight gain was obtained. The weight gain of the test coupon type 1 after treatment with said solution was 10.3 mg/dm$^2$. The weight gain indicates that smear is not removed from the dielectric material. It is assumed that the dielectric material swells during the treatment with such a treatment solution which is then partially included in the swollen dielectric material.

The copper etching rate as determined with a test coupon type 2 was 0.077 $\mu$m/min.

Additional, a test was done with a treatment solution temperature of 35 °C and a treatment time of 15 min.

Instead of weight loss, weight gain was obtained. The weight gain of the test coupon after treatment with said solution was 10.5 mg/dm$^2$.

The copper etching rate as determined with a test coupon type 2 was 0.792 $\mu$m/min. The copper etching rate is too high for a smear removal process.

Example 3

Test coupons of type 1 and 2 were contacted with an acidic aqueous solution containing 75 wt.-% and 5 wt.-% ammonium peroxodisulfate. The treatment solution temperature was adjusted to 35 °C and the treatment time was 30 min.

No swelling step in a solution comprising an organic solvent was applied prior to step (ii).

The weight loss of the test coupon after treatment with said solution was 80 mg/dm$^2$. Accordingly, etching of the dielectric material of test coupon type 1 is acceptable.

The copper etching rate as determined with a test coupon type 2 was 0.08 $\mu$m/min which is a desired low copper etching rate.

Example 4

Test coupons of types 1 and 2 were contacted with an acidic aqueous solution containing 75 wt.-% and 5 wt.-% ammonium peroxodisulfate. The treatment solution temperature was adjusted to 35 °C and the treatment time was 30 min.

A swelling step in a solution comprising butylglycol as the organic solvent (1 min at 70 °C) was applied prior to step (ii).

The weight loss of the test coupon type 1 after treatment with said solution was 60 mg/dm$^2$ and is in the desired range.

The copper etching rate as determined with a test coupon type 2 was 0.16 $\mu$m/min and is in the desired range.

Example 5

Test coupons of types 1 and 2 were contacted with an acidic aqueous solution containing 75 wt.-% and 10 wt.-% ammonium peroxodisulfate. The treatment solution temperature was adjusted to 22 °C and the treatment time was 15 min.

No swelling step in a solution comprising an organic solvent was applied prior to step (ii).

The weight loss of the test coupon type 1 after treatment with said solution was 75 mg/dm$^2$. Accordingly, smear is sufficiently removed from the dielectric material.

The copper etching rate as determined with a test coupon type 2 was 0.03 $\mu$m/min and is in the desired range.

**Claims**

1. A method for treatment of recessed structures in a dielectric material for smear removal comprising, in this order, the steps of

   (i) providing a dielectric material comprising at least one recessed structure which contains residues of said dielectric material formed during manufacture of said recessed structures and
   (ii) contacting said dielectric material with an aqueous solution comprising 60 to 80 wt.-% sulfuric acid and 0.04 to 0.66 mol/l peroxodisulfate ions and thereby removing said residues of dielectric material from the dielectric material.

2. The method for treatment of recessed structures in a dielectric material for smear removal according to claim 1 wherein the dielectric material comprises a thermoplastic polymer selected from the group consisting of epoxy resins, polyimide, cyanate esters, polyester, acrylonitrile-butadiene-styrene copolymer, polycarbonates, acrylonitrile-butadiene-styrene - polycarbonate composites, polyamide and polycyclo-olefine.

3. The method for treatment of recessed structures in a dielectric material for smear removal according to any of the foregoing claims wherein the dielectric substrate comprises a glass reinforcement.

4. The method for treatment of recessed structures in a dielectric material for smear removal according to any of the foregoing claims wherein the dielectric material further comprises copper structures and/or copper layers.

5. The method for treatment of recessed structures in a dielectric material for smear removal according to any of the foregoing claims wherein the concentration of sulfuric acid in the aqueous solution applied in step (ii) ranges from 65 to 75 wt.-%.

6. The method for treatment of recessed structures in a dielectric material for smear removal according to any of the foregoing claims wherein the concentration of peroxidisulfate ions in the aqueous solution applied in step (ii) ranges from 0.22 to 0.44 mol/l.

7. The method for treatment of recessed structures in a dielectric material for smear removal according to any of the foregoing claims wherein the aqueous solution applied in step (ii) further comprises one or more complexing agents for copper ions selected from (poly)aminocarboxylates and phosphonates, additives which improve the shelf life of said aqueous solution selected from alcohols and polyols and corrosion inhibitors for copper selected from triazoles.

8. The method for treatment of recessed structures in a dielectric material for smear removal according to any of the foregoing claims wherein the temperature of the aqueous solution is held during step (ii) at a temperature in the range of 10 to 80 °C.

9. The method for treatment of recessed structures in a dielectric material for smear removal according to any of the foregoing claims wherein the temperature of the aqueous solution is held during step (ii) at a temperature in the range of 20 to 60 °C.

10. The method for treatment of recessed structures in a dielectric material for smear removal according to any of the foregoing claims wherein the dielectric substrate is contacted in step (ii) with the aqueous solution for 1 to 60 min.

11. The method for treatment of recessed structures in a dielectric material for smear removal according to any of the foregoing claims wherein the dielectric substrate is contacted in step (ii) with the aqueous solution for 5 to 40 min.

12. The method for treatment of recessed structures in a dielectric material for smear removal according to any of the foregoing claims wherein the dielectric substrate is contacted prior to step (ii) with an aqueous solution comprising an organic solvent.

13. The method for treatment of recessed structures in a dielectric material for smear removal according to any of the foregoing claims wherein the dielectric substrate is rinsed with water comprising an alkaline substance after step (ii).

14. The method for treatment of recessed structures in a dielectric substrate for smear removal according to any of the foregoing claims, further comprising the steps of

(iii) contacting said dielectric substrate with a solution comprising ions and/or colloids of a catalytic metal which initiates electroless copper plating and
(iv) contacting the dielectric substrate with an electroless copper plating bath composition and thereby depositing a first copper layer onto the activated dielectric substrate.

15. An aqueous solution for treatment of recessed structures in a dielectric material for smear removal comprising 60 to 80 wt.-% sulfuric acid and 0.04 to 0.66 mol/l peroxodisulfate ions.

Europäisches
Patentamt

European
Patent Office

Office européen
des brevets

**EUROPEAN SEARCH REPORT**

Application Number

EP 13 18 5890

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y | DE 20 10 438 A1 (SCHERING AG)<br>9 September 1971 (1971-09-09)<br>* page 2, paragraph 1 - page 7, paragraph 1; example 1 *<br>* example zusammensetzung e) *<br>----- | 1,2,5,6,<br>8-11,15<br>3,4,13,<br>14 | INV.<br>C23C18/24<br>C23C18/54<br>H05K3/00 |
| X<br>A | DE 15 69 434 A1 (SCHERING AG)<br>26 June 1969 (1969-06-26)<br>* page 1, paragraph 1 - page 3, paragraph 3 *<br>* page 3, paragraph 5 - page 4, paragraph 5 *<br>* page 5, paragraph 2 *<br>* example 3c) *<br>----- | 15<br>1-14 | |
| X<br>A | US 3 553 085 A (HEYMANN KURT)<br>5 January 1971 (1971-01-05)<br>* column 1, line 12 - column 2, line 58 *<br>* example 6 *<br>* column 4, line 3 - line 27 *<br>----- | 15<br>1-14 | |
| Y,D | EP 0 216 513 A2 (UNION CARBIDE CORP [US])<br>1 April 1987 (1987-04-01)<br>* page 49 - page 51; examples 3, 4 *<br>----- | 3,4,13,<br>14 | TECHNICAL FIELDS<br>SEARCHED (IPC)<br><br>C23C<br>H05K<br>C23F |
| Y | US 3 276 927 A (MEDFORD ROBERT J)<br>4 October 1966 (1966-10-04)<br>* column 1, line 8 - column 3, line 39; table I *<br>* examples 1,2,22; table II *<br>* column 4, line 21 - line 38 *<br>----- | 3,4 | |

The present search report has been drawn up for all claims

| Place of search | Date of completion of the search | Examiner |
|---|---|---|
| Munich | 25 February 2014 | Handrea-Haller, M |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

........................................................................

& : member of the same patent family, corresponding
   document

EPO FORM 1503 03.82 (P04C01)

**ANNEX TO THE EUROPEAN SEARCH REPORT
ON EUROPEAN PATENT APPLICATION NO.**

EP 13 18 5890

This annex lists the patent family members relating to the patent documents cited in the above-mentioned European search report.
The members are as contained in the European Patent Office EDP file on
The European Patent Office is in no way liable for these particulars which are merely given for the purpose of information.

25-02-2014

| Patent document cited in search report | | Publication date | Patent family member(s) | | Publication date |
|---|---|---|---|---|---|
| DE 2010438 | A1 | 09-09-1971 | CS | 166260 B2 | 27-02-1976 |
| | | | DE | 2010438 A1 | 09-09-1971 |
| | | | PL | 82788 B1 | 31-10-1975 |
| | | | RO | 57550 A1 | 15-12-1974 |
| | | | YU | 212770 A | 10-09-1979 |
| DE 1569434 | A1 | 26-06-1969 | NONE | | |
| US 3553085 | A | 05-01-1971 | NONE | | |
| EP 0216513 | A2 | 01-04-1987 | CA | 1267350 A1 | 03-04-1990 |
| | | | EP | 0216513 A2 | 01-04-1987 |
| | | | JP | S6296680 A | 06-05-1987 |
| US 3276927 | A | 04-10-1966 | NONE | | |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0216513 A
- US 4023998 A
- EP 0216513 A2

**Non-patent literature cited in the description**

- Surface Engineering. ASM Handbook. vol. 5, 317-318
- Surface Engineering. ASM Handbook. vol. 5, 311-312